Europäisches Patentamt

European Patent Office

Office européen des brevets

(11) Veröffentlichungsnummer: **0 431 215 A1**

## (12) EUROPÄISCHE PATENTANMELDUNG

(21) Anmeldenummer: **89122721.7**

(51) Int. Cl.⁵: **H03K 17/08**

(22) Anmeldetag: **08.12.89**

(43) Veröffentlichungstag der Anmeldung:
**12.06.91 Patentblatt 91/24**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**W-8000 München 2(DE)**

(72) Erfinder: **Baudelot, Eric, Dr.Ing.**
**Spinnereistrasse 14**
**W-8520 Erlangen(DE)**
Erfinder: **Laber, Hans, Dipl.-Ing.**
**Schwedlerstrasse 31**
**W-8520 Erlangen(DE)**

(54) **Verfahren zum Schutz eines abschaltbaren Thyristors vor unzulässiger Überspannung und Schaltungsanordnung zur Durchführung des Verfahrens.**

(57) Die Erfindung bezieht sich auf ein Verfahren zum Schutz eines mit einer aus einem Einschaltkreis (4) und einem Ausschaltkreis (6) bestehenden Ansteuerschaltung versehenen abschaltbaren Thyristors (2) vor unzulässiger Überspannung und auf eine Schaltungsanordnung zur Durchführung des Verfahrens. Erfindungsgemäß wird die Anodenspannung des abschaltbaren Thyristors (2) in Bezug auf seine Kathodenspannung überwacht und bei Überschreitung eines vorbestimmten Grenzwertes wird ein Steuersignal generiert, wodurch die am Gate des abschaltbaren Thyristors (2) angeschaltete negative Spannungsquelle (10) abgeschaltet und der abschaltbare Thyristor (2) mittels des Einschaltkreises (4) eingeschaltet wird. Somit kann man abschaltbare Thyristoren (2) ohne großen Aufwand vor unzulässiger Überspannung schützen.

FIG 3

## VERFAHREN ZUM SCHUTZ EINES ABSCHALTBAREN THYRISTORS VOR UNZULÄSSIGER ÜBERSPANNUNG UND SCHALTUNGSANORDNUNG ZUR DURCHFÜHRUNG DES VERFAHRENS

Die Erfindung bezieht sich auf ein Verfahren zum Schutz eines mit einer aus einem Einschaltkreis und einem Ausschaltkreis bestehenden Ansteuerschaltung versehenen abschaltbaren Thyristors vor unzulässiger Überspannung und auf eine Schaltungsanordnung zur Durchführung des Verfahrens.

Aus der Zeitschrift "Elektronik", Heft 20, vom 05.10.1984, Seiten 111 bis 115, und der Zeitschrift "Elektronik", Heft 21, vom 19.10.1984, Seiten 91 bis 96, sind eine optimierte Ansteuerschaltung, bestehend aus einem Einschaltkreis und einem Ausschaltkreis, für abschaltbare Thyristoren (Gate-Turn-Off-Thyristoren auch GTO-Thyristoren), insbesondere abschaltbare Leistungsthyristoren, bekannt. Dabei wird im erstgenannten Aufsatz der Einschaltkreis und im zweitgenannten Aufsatz der Ausschaltkreis näher behandelt.

Aus der Zeitschrift "Elektroniker", Nr. 5, 1984, Seiten 49 bis 56, insbesondere Seite 52, ist ein Steuergenerator für einen Hochleistungs-GTO-Thyristor bekannt. Dieser Steuergenerator enthält einen Einschaltkreis, einen Ausschaltkreis und einen Sperrkreis, der das Gate des Hochleistungs-GTO-Thyristors mit einer negativen Gate-Spannung während der Sperrphase versorgt. Der Steuergenerator ist mit Leistung-Metalloxidschicht-Feld-effekttransistoren (Leistungs-MOSFET) aufgebaut.

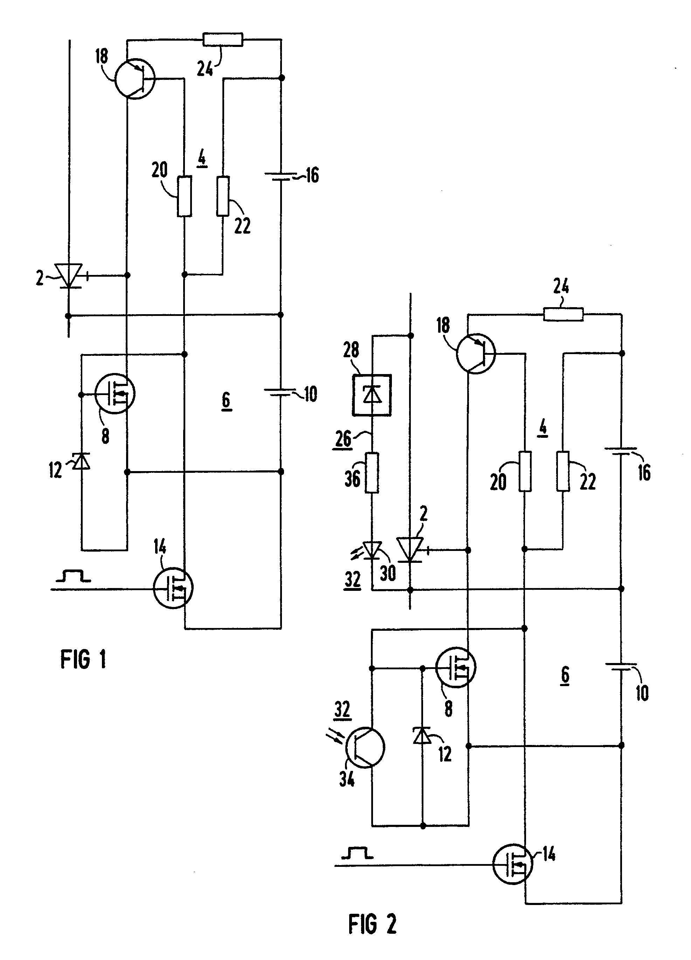

In Figur 1 ist eine Ansteuerschaltung für einen GTO-Thyristor 2 näher dargestellt. Die Ansteuerschaltung enthält einen Einschaltkreis 4 und einen Ausschaltkreis 6. Der Ausschaltkreis 6, der während der Sperrphase das Gate des GTO-Thyristors 2 mit einer negativen Gate-Spannung versorgt, besteht aus einem selbstsperrenden MOSFET 8 und einer Spannungsquelle 10. Dem MOSFET 8 ist zur Gate-Source-Strecke eine Zener-Diode 12 elektrisch parallel geschaltet, so daß die Gate-Spannung begrenzt ist. Der Einschaltkreis 4 besteht aus einem selbstsperrenden MOSFET 14, einer Spannungsquelle 16 und einem pnp-Transistor 18, wobei dessen Basis über einen Widerstand 20 einerseits mit dem Drainanschluß des selbstsperrenden MOSFET 14 und andererseits über einen Widerstand 22 mit dem Plus-Pol der Spannungsquelle 16 verbunden ist. Die Spannungsquelle 16 ist mittels eines Widerstands 24 mit dem Emitter des pnp-Transistors 18 elektrisch leitend verbunden. Der selbstsperrende MOSFET 14 erhält von einer nicht näher dargestellten Steuerung ein Einschalt-Signal, wodurch der MOSFET 14 leitet und der MOSFET 8, da sein Gateanschluß mit dem Drainanschluß des selbstsperrenden MOSFET 14 des Einschaltkreises 4 verbunden ist, sperrt. Bei einem Ausschalt-Signal wird der selbstsperrende MOSFET 14 gesperrt und der selbstsperrende MOSFET 8 wird durch den Sperrzustand des selbstsperrenden MOSFET 14 leitend, wobei sein Gatepotential und damit das Drainpotential des selbstsperrenden MOSFET 14 des Einschaltkreises 4 mittels der Zener-Diode 12 auf einen vorbestimmten Z-Wert geklemmt wird. Während der Sperrphase bleibt der MOSFET 8 leitend, wodurch am Gate des GTO-Thyristors 2 die Spannungsquelle 10 angeschlossen ist, wodurch der GTO-Thyristor 2 gesperrt bleibt.

Aus der Zeitschrift "BBC-Nachrichten", 1977, Heft 3/4, Seiten 152 bis 158, sind Schutzmaßnahmen für einen Thyristor bekannt. Als Schutzelemente werden spannungsbegrenzende Elemente verwendet, wie z.B. Varistoren (Silicium-Karbit-Varistor, Oxidvaristor), zwei in Antiserie geschaltete stoßspannungsfeste Silicium Dioden (BBC-DASAS-Elemente) oder Kippdiode, auch Break-Over-Diode (BOD) genannt. BOD-Elemente sind auf definierte Kippspannungen dimensionierte Thyristoren ohne herausgeführten Gateanschluß. Sie zünden durch Überschreiten der Null-Kippspannung und zünden den zu schützenden Thyristor, zu dessen Anoden-Gate-Strecke ein BOD-Element elektrisch parallel geschaltet ist.

Diese bei Thyristoren angewendete Schutzmaßnahme, wobei ein BOD-Element mit einem Vorwiderstand die Anode des zu schützenden Thyristors mit seinem Gate verknüpft, kann bei GTO-Thyristoren als Schutzmaßnahme nicht angewendet werden, da der GTO-Thyristor mit einer negativen Gate-Spannung im Sperrzustand gehalten wird. Beim Einsatz eines BOD-Elementes, wie beim Überspannungsschutz eines Thyristors, würde beim Ansprechen auf Überspannung der Strom durch das BOD-Element in die negative Spannungsquelle abfließen und nicht als Zündstrom wirksam werden. D.h., der mit einem spannungsbegrenzenden Element aufgebaute Überspannungsschutz, der elektrisch parallel zur Anoden-Gate-Strecke des GTO-Thyristors geschaltet ist, wie bei der Überspannungsschutzmaßnahme von Thyristoren, könnte einen GTO-Thyristor gegen Überspannungen nicht schützen.

Der Erfindung liegt nun die Aufgabe zugrunde, ein Verfahren zum Schutz eines GTO-Thyristors gegen unzulässige Überspannung und eine Schaltungsanordnung zur Durchführung des Verfahrens anzugeben.

Diese Aufgabe wird erfindungsgemäß dadurch gelöst, daß die Anodenspannung des abschaltbaren Thyristors in Bezug auf seine Kathodenspannung überwacht wird und bei Überschreitung eines vorbestimmten Grenzwertes ein Steuersignal generiert wird, wodurch die am Gate angeschaltete negative Spannungsquelle abgeschaltet und der abschaltbare Thyristor mittels des Einschaltkreises eingeschaltet wird.

Durch die Verwendung des in Abhängigkeit der an der Anode des GTO-Thyristors anstehenden Spannung in Bezug auf seine Kathodenspannung erzeugten Steuersignals als Betätigungssignal für den Ausschaltkreis und den Einschaltkreis ist es möglich, den abschaltbaren Thyristor gegen Überspannung wirkungsvoll zu schützen. Das generierte Steuersignal schaltet die am Gate anstehende negative Spannungsquelle ab und aktiviert den Einschaltkreis. Der so aktivierte Einschaltkreis zündet den abschaltbaren Thyristor bevor er durch Überspannung zerstört wird.

Bei einem vorteilhaften Verfahren wird das Steuersignal bzw. der Steuerstrom zusätzlich dem Gate des abschaltbaren Thyristors als Zündstrom zugeführt, wodurch dieser zündet. Dadurch, daß der Ausschaltkreis ausgeschaltet wird, d.h., die an dem Gate des abschaltbaren Thyristors angeschaltete negative Spannungsquelle wird abgeschaltet, kann das Steuersignal bzw. der Steuerstrom nicht mehr in die negative Spannungsquelle abfließen, sondern wird zum Einschalten des Einschaltkreises verwendet. Ebenfalls wird erreicht, daß selbst wenn der Einschaltkreis defekt ist, der abschaltbare Thyristor gezündet wird, so daß die anstehende Überspannung den abschaltbaren Thyristor nicht zerstören kann.

Bei einem weiteren Verfahren zum Schutz des mit einer aus einem Einschaltkreis, einem Ausschaltkreis und einem Sperrkreis bestehenden Ansteuerschaltung versehenen abschaltbaren Thyristors vor unzulässiger Überspannung wird die Anodenspannung des abschaltbaren Thyristors in Bezug auf seine Kathodenspannung überwacht und bei Überschreitung eines vorbestimmten Grenzwertes ein Steuersignal generiert, das dem Gate des abschaltbaren Thyristors als Zündstrom zugeführt wird. Bei ausgeschaltetem Ausschaltkreis ist die Gate-Kathoden-Strecke des abschaltbaren Thyristors niederohmiger als der Sperrkreis, wodurch sich das Steuersignal bzw. der Steuerstrom umgekehrt zum Verhältnis der Widerstandswerte aufteilt. Auch bei diesem Verfahren kann das Steuersignal bzw der Steuerstrom nicht in die negative Spannungsquelle abfließen, sondern wird überwiegend dem Gate des abschaltbaren Thyristors als Zündstrom zugeführt.

Bei einer erfindungsgemäßen Schaltungsanordnung zur Durchführung des Verfahrens mit einem abschaltbaren Thyristor, der mit einer Ansteuerschaltung versehen ist, die aus einem Einschaltkreis und einem Ausschaltkreis besteht, ist elektrisch parallel zur Anoden-Kathoden-Strecke des abschaltbaren Thyristors eine Reihenschaltung, bestehend aus einem spannungsbegrenzenden Element und einem sendeseitigen Teil eines Kopplungselementes, geschaltet und ist der empfangsseitige Teil des Kopplungselementes derart mit dem Betätigungseingang des Ausschaltkreises und den Einschaltkreises verbunden, daß der Ausschaltkreis abschaltbar und der Einschaltkreis einschaltbar sind. Durch diese Schaltungsanordnung überbrückt das generierte Steuersignal auf der Empfangsseite des Kopplungselementes den Betätigungseingang des Ausschaltkreises und steuert einen Schalter des Einschaltkreises an, wodurch der Ausschaltkreis abgeschaltet und der Einschaltkreis eingeschaltet werden. Mit Einschalten des Einschaltkreises wird der abschaltbare Thyristor gezündet, wodurch die am abschaltbaren Thyristor anstehende Überspannung abgeleitet wird.

Bei einer weiteren erfindungsgemäßen Schaltungsanordnung zur Durchführung des Verfahrens mit einem abschaltbaren Thyristor, der mit einer aus einer Diode, einem Widerstand und einem Kondensator bestehenden Schutzbeschaltung, und mit einer Ansteuerschaltung versehen ist, die aus einem Einschaltkreis und einem Ausschaltkreis besteht, ist elektrisch parallel zum Kondensator der Schutzbeschaltung eine Reihenschaltung, bestehend aus einem spannungsbegrenzenden Element und einem sendeseitigen Teil eines Kopplungselementes, geschaltet und ist ein empfangsseitiger Teil des Kopplungselementes mit dem Betätigungseingang eines Schalters verbunden, mit dem der Ausschaltkreis ausschaltbar und der Einschaltkreis einschaltbar sind. Bei dieser Schaltungsanordnung wird die Spannung am Kondensator der Schutzbeschaltung des ab-schaltbaren Thyristors in Bezug auf die Kathodenspannung des abschaltbaren Thyristors überwacht. Übersteigt diese Spannung einen vorbestimmten Grenzwert, wird ein Steuersignal generiert, das ebenfalls mittels eines Schalters den Ausschaltkreis abund den Einschaltkreis einschaltet.

Bei einer weiteren vorteilhaften erfindungsgemäßen Schaltungsanordnung zur Durchführung des Verfahrens mit einem abschaltbaren Thyristor, der mit einer Ansteuerschaltung versehen ist, die aus einem Einschaltkreis und einem Ausschaltkreis besteht, ist die Anode des abschaltbaren Thyristors über eine Reihenschaltung, bestehend aus einem spannungsbegrenzenden Element, einem sendeseitigen Teil eines Kopplungselementes und einer Entkopplungsdiode, mit seinem Gate verknüpft und ist ein empfangsseitiges Teil des Kopplungselementes mit dem Betätigungseingang eines Schalters verbunden, mit dem der Ausschaltkreis abschaltbar und der Einschaltkreis einschaltbar sind. Bei dieser Schaltungsanordnung wird zusätzlich das generierte Steuersignal bzw. der Steuerstrom dem Gate des abschaltbaren Thyristors als Zündstrom zugeführt. Somit kann ein abschaltbarer Thyristor vor unzulässiger Überspannung geschützt werden, selbst wenn der Einschaltkreis defekt ist.

Diese zusätzliche Schutzmaßnahme wird ebenfalls bei der Schaltungsanordnung angewendet, mit der die Spannung am Kondensator der Schutzbeschaltung des abschaltbaren Thyristors überwacht wird.

Bei einer weiteren erfindungsgemäßen Schaltungsanordnung zur Durchführung des Verfahrens mit einem abschaltbaren Thyristor, der mit einer Ansteuerschaltung, die aus einem Einschaltkreis und einem Ausschaltkreis besteht, versehen ist, ist elektrisch parallel zur Anoden-Gate-Strecke des abschaltbaren Thyristors ein Zündthyristor mit einem Vorwiderstand geschaltet, wobei das Gate des Zündthyristors über eine Reihenschaltung, bestehend aus einem spannungsbegrenzenden Element und einem sendeseitigen Teil des Kopplungselementes, mit der Anode des abschaltbaren Thyristors verknüpft und ist ein empfangsseitiger Teil des Kopplungselementes mit dem Betätigungseingang eines Schalters verbunden ist, mit dem der Abschaltkreis abschaltbar und der Einschaltkreis einschaltbar sind. Bei dieser Schaltungsanordnung wird bei Überspannung der abschaltbare Thyristor mittels eines überspannungsgeschützten Thyristors, dessen Spannungsfestigkeit der Spannungsfestigkeit des abschaltbaren Thyristors entspricht, gezündet, wobei gleichzeitig der Abschaltkreis abgeschaltet und der Einschaltkreis eingeschaltet wird. Durch die Schutzzündung des abschaltbaren Thyristors mittels des Zündthyristors ist der abschaltbare Thyristor wegen unzulässiger Überspannung selbst dann geschützt, wenn der Einschaltkreis defekt ist.

Bei einer weiteren erfindungsgemäßen Schaltungsanordnung zur Durchführung des Verfahrens mit einem abschaltbaren Thyristor, der mit einer Ansteuerschaltung, die aus einem Einschaltkreis, einem Ausschaltkreis und einem Sperrkreis besteht, versehen ist, ist elektrisch parallel zur Anoden-Gate-Strecke des abschaltbaren Thyristors eine Reihenschaltung, bestehend aus einem spannungsbegrenzenden Element und einem Widerstand, geschaltet. Da die Ansteuerschaltung einen Sperrkreis hat, wodurch die negative Spannungsquelle hochohmiger an das Gate angeschlossen ist, als beim Ausschaltkreis und die Gate-Kathoden-Strecke des abschaltbaren Thyristors niederohmiger ist als der Sperrkreis, wird das generierte Steuersignal überwiegend als Zündstrom dem Gate des abschaltbaren Thyristors zugeführt (Stromamplitudenverhältnis umgekehrt proportional zum Widerstandsverhältnis). Somit erübrigt sich die Abschaltung des Ausschaltkreises und die Einschaltung des Einschaltkreises.

Zur weiteren Erläuterung der Erfindung wird auf die Zeichnung Bezug genommen, in der Ausführungsbeispiele der Schaltungsanordnung zur Durchführung des erfindungsgemäßen Verfahrens zum Schutz eines abschaltbaren Thyristors vor unzulässiger Überspannung schematisch veranschaulicht sind.

Figur 1 zeigt einen abschaltbaren Thyristor mit einer bekannten Ansteuerschaltung, in den

Figuren 2 bis 5 sind jeweils eine Schaltungsanordnung zur Durchführung des erfindungsgemäßen Verfahrens dargestellt, die

Figuren 6 und 7 zeigen vorteilhafte Ausgestaltungen der Schaltungsanordnung der Figuren 4 und 5 und in den

Figuren 8 und 9 sind jeweils eine weitere Schaltungsanordnung zur Durchführung des erfindungsgemäßen Verfahrens angegeben.

In den Figuren 1 bis 9 sind gleiche Bauteile mit gleichen Bezugszeichen versehen.

In der Figur 2 ist eine Schaltungsanordnung zur Durchführung des erfindungsgemäßen Verfahrens dargestellt. Dabei ist der abschaltbare Thyristor 2, mit der bekannten Ansteuerschaltung nach Figur 1, mit einer Reihenschaltung 26 versehen, die elektrisch parallel zur Anoden-Kathoden-Strekke des GTO-Thyristors 2 geschaltet ist. Die Reihenschaltung 26 besteht aus einem spannungsbegrenzenden Element 28 und einem sendeseitigen Teil 30 eines Kopplungselementes 32. Der empfangsseitige Teil 34 des Kopplungselementes 32 ist elektrisch parallel zur Gate-Source-Strecke des selbstsperrenden MOSFET 8 des Ausschaltkreises 6 der Ansteuerschaltung geschaltet. Als sendeseitiger Teil 30 ist eine lichtemittierende Diode (LED) und als empfangsseitiger Teil 34 ist ein Fototransistor vorgesehen, die mittels eines Lichtwellenleiters miteinander gekoppelt sind. Als spannungsbegrenzendes Element 28 kann eine Kippdiode mit einem Widerstand 36 vorgesehen sein. Kippdioden, auch Break-Over-Diode (BOD) genannt, sind auf definierte Kippspannungen dimensionierte Thyristoren ohne herausgeführten Gateanschluß. Sie zünden durch Überschreiten der Nullkippspannung. Weitere spannungsbegrenzende Elemente 28 sind ein Varistor mit einer elektrisch in Reihe geschalteten Trigger-Diode, auch Diac genannt, oder auch eine Zener-Diode mit einer elektrisch in Reihe geschalteten Trigger-Diode. Durch diese Kombinationen erhält man spannungsbegrenzende Elemente 28, die eine Kennlinie gemäß einer Kippdiode aufweisen.

Mittels des spannungsbegrenzenden Elementes 28 wird die Anodenspannung des GTO-Thyristors 2 in Bezug auf seine Kathodenspannung überwacht. Überschreitet die Anodenspannung des GTO-Thyristors 2 einen mittels des spannungsbegrenzenden Elementes 28 eingestellten Grenzwert, so zündet das spannungsbegrenzende Element 28 und ein Steuersignal bzw. ein Steuerstrom beginnt zu fließen. Dieser Steuerstrom wird mittels des sendeseitigen Teils 30 des Kopplungselementes 32 in ein Lichtsignal gewandt, der den empfangsseitigen Teil 34 des Kopplungselementes 32 leitend schaltet, wodurch die Gate-Source-Strecke des selbstsperrenden MOSFET 8 des Ausschaltkreises 6 überbrückt wird. Dadurch geht der selbstsperrende MOSFET 8 in den Sperrzustand, wodurch die negative Spannungsquelle 10 vom Gate des GTO-Thyristors 2 abgeschaltet und mittels des pnp-Transistors 18 des Einschaltkreises 4 die positive Spannungsquelle 16 an das Gate des GTO-Thyristors 2 angeschaltet wird. Dadurch wird der GTO-Thyristor 2 leitend und die an der Anoden-Kathoden-Strecke des GTO-Thyristors 2 anstehende Überspannung wird abgebaut. Durch Unterschreiten des Grenzwertes des spannungsbegrenzenden Elementes 28 wird das Steuersignal bzw. der Steuerstrom unterbunden, wodurch der empfangsseitige Teil 34 des Kopplungselementes 32 in den Sperrzustand geht und damit der selbstsperrende MOSFET 8 leitend wird, wobei das Gatepotential durch die Zener-Diode 12 begrenzt wird. Somit wird an das Gate des GTO-Thyristors 2 wieder die negative Spannungsquelle 10 angeschlossen, wodurch der GTO-Thyristor 2 sperrt und in dem Sperrzustand gehalten wird.

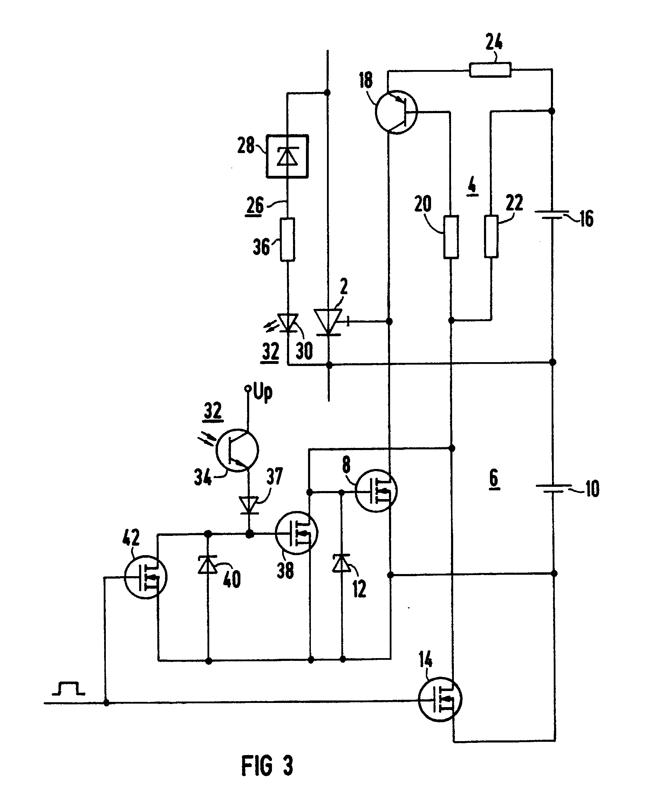

Bei der in der Figur 3 dargestellten Schaltungsanordnung ist der empfangsseitige Teil 34 des Kopplungselementes 32 kollektorseitig mit einer positiven Spannungsquelle $U_p$ und emitterseitig über eine Entkopplungsdiode 37 mit dem Gateanschluß eines selbstsperrenden MOSFET 38 elektrisch leitend verbunden. Mit diesem selbstsperrenden MOSFET 38 ist die Gate-Source-Strecke des MOSFET 8 des Ausschaltkreises 6 überbrückbar. Außerdem ist elektrisch parallel zur Gate-Source-Strecke des selbstsperrenden MOSFET 38 eine Zener-Diode 40 und die Drain-Source-Strecke eines weiteren MOSFET 42 geschaltet. Das Gate dieses MOSFET 42 ist mit dem Eingang des Einschaltkreises 4 (Gate des selbstsperrenden MOSFET 14) elektrisch leitend verbunden.

Sobald ein Steuersignal bzw. ein Steuerstrom in der Reihenschaltung 26 generiert wird, wird der selbstsperrende MOSFET 38 mittels des Kopplungselementes 32 leitend, wodurch der MOSFET 8 des Ausschaltkreises 6 in den Sperrzustand geht und der pnp-Transistor 18 des Einschaltkreises 4 leitend wird. Dadurch wird der GTO-Thyristor 2 leitend und die anstehende Überspannung wird abgebaut. Nachdem kein Steuersignal mehr generiert wird, wird nicht wieder die negative Spannungsquelle 10 an das Gate des GTO-Thyristors 2 angeschlossen, sondern die positive Spannungsquelle 16 bleibt am Gate des GTO-Thyristors 2 angeschlossen. Dies wird dadurch erreicht, weil die Kapazität der Gate-Source-Strecke des MOSFET 38 infolge der Zener-Diode 40 und der Entkopplungsdiode 37 nicht entladen werden kann. Damit dieser Überspannungsschutz wieder zurückgesetzt werden kann, ist der selbstsperrende MOSFET 42 vorhanden. Mit dem nächsten Einschalt-Befehl aus einer nicht näher dargestellten Steuerung wird der MOSFET 14 und 42 leitend, wodurch der pnp-Transistor 18 angesteuert und die Gate-Source-Strecke des MOSFET 38 überbrückt werden, wodurch der MOSFET 38 sperrt. Somit ist die Überspannungsschutzschaltung zurückgesetzt, wodurch von der nicht näher darstellten Steuerung fortlaufend Einschalt- und Ausschalt-Befehle an die Ansteuerschaltung geleitet werden können, die den GTO-Thyristor 2 auch ein- und ausschalten können. Ist der MOSFET 42 nicht vorhanden, kann der GTO-Thyristor 2 nicht mehr ausgeschaltet werden.

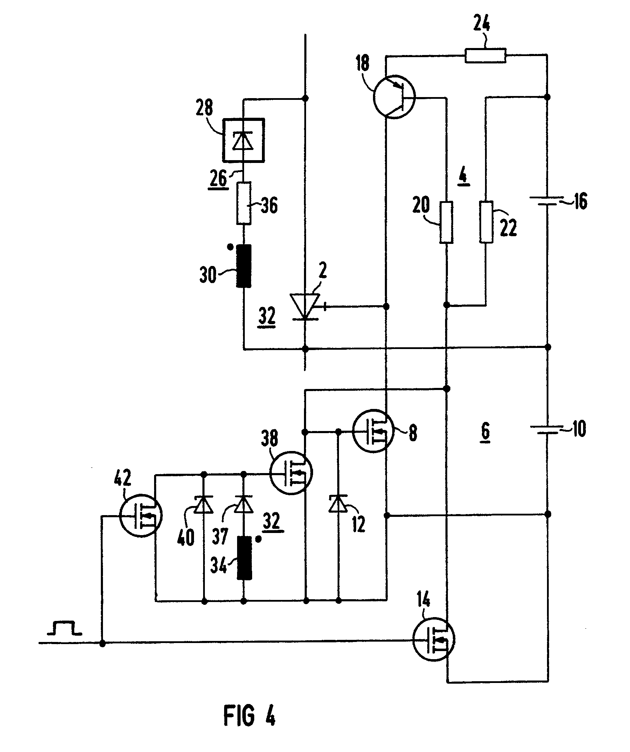

Als Kopplungselement 32 kann auch ein Übertrager vorgesehen sein. In der Figur 4 ist eine Schaltungsanordnung dargestellt, die als Kopplungselement 32 einen Übertrager aufweist. Der empfangsseitige Teil 34 des Kopplungselementes 32 ist über die Entkopplungsdiode 37 mit dem Gateanschluß des selbstsperrenden MOSFET 38 verbunden. D.h., diese Schaltungsanordnung entspricht mit Ausnahme des Kopplungselementes 32 der Schaltungsanordnung gemäß Figur 3 .

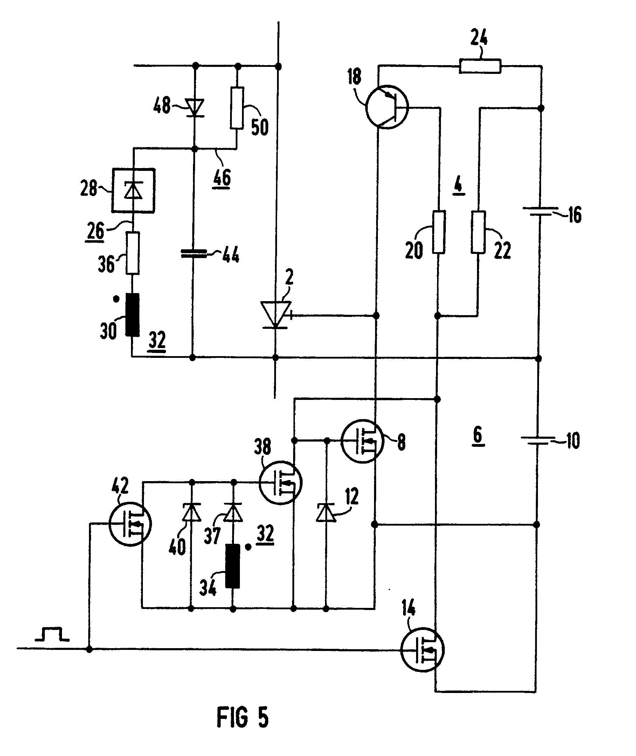

In der Figur 5 ist eine Schaltungsanordnung gemäß Figur 4 dargestellt, wobei das spannungsbegrenzende Element 28 die Spannung an einem Kondensator 44 einer Schutzbeschaltung 46 des GTO-Thyristors 2 in Bezug auf sein Kathodenpotential überwacht. Die bekannte Schutzbeschaltung 46 enthält ferner eine Diode 48 und einen Widerstand 50.

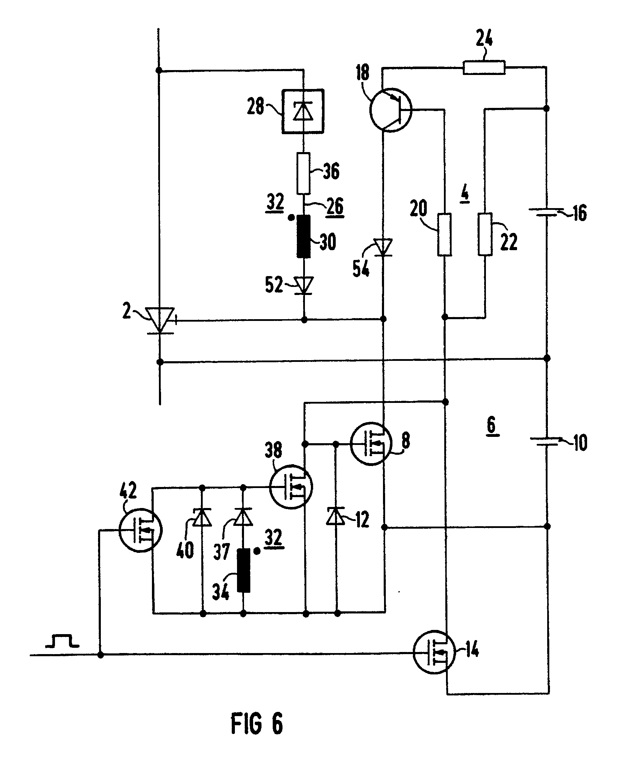

In der Figur 6 ist eine vorteilhafte Ausführungsform der Schaltungsanordnung nach Figur 4 dargestellt Bei dieser Ausführungsform ist die Reihenschaltung 26 elektrisch parallel zur Anoden-Gate-Strecke des GTO-Thyristors 2 geschaltet. Dadurch wird erreicht, daß bei Überschreitung eines vorbestimmten Spannungsgrenzwertes ein Steuersignal bzw. ein Steuerstrom generiert wird, der einerseits die negative Spannungsquelle 10 vom Gateanschluß des GTO-Thyristors 2 abschaltet und die positive Spannungsquelle 16 an das Gate des GTO-Thyristors 2 anschaltet, wodurch der GTO-Thyristor 2 leitend wird. Außerdem wird der generierte Steuerstrom als Zündstrom dem Gate des GTO-Thyristors 2 zugeführt. Dadurch wird sichergestellt, daß der GTO-Thyristor 2 selbst bei defekten Einschaltkreis 4 bei unzulässiger Überspannung gezündet wird. Damit ein vom Einschaltkreis erzeugter Gatestrom nicht durch die Reihenschaltung 26 abfließt, ist die Reihenschaltung 26 um eine Entkopplungsdiode 52 erweitert. Außerdem ist der Einschaltkreis 4 durch eine Entkopplungsdiode 54 vom Gate des GTO-Thyristors 2 entkoppelt.

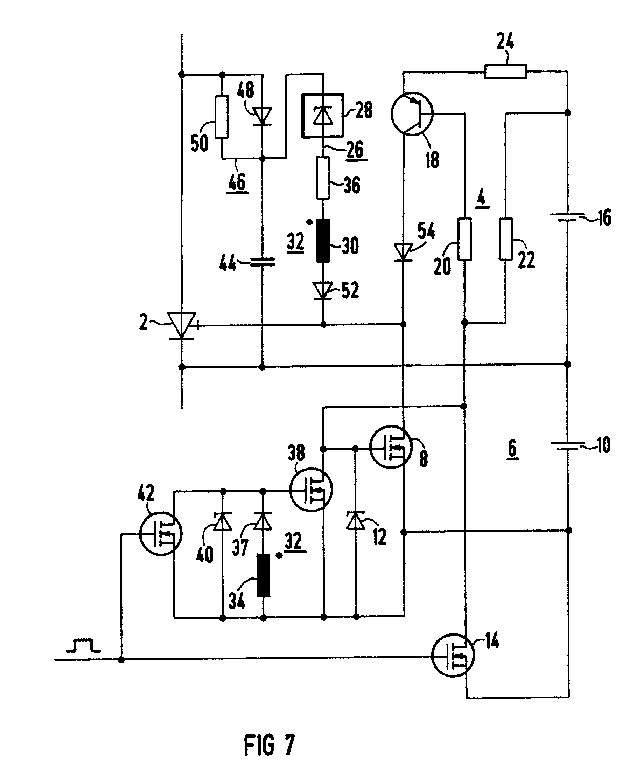

In Figur 7 ist eine vorteilhafte Ausführungsform der Schaltungsanordnung nach Figur 5 dargestellt. Auch bei dieser Ausführungsform wird das generierte Steuersignal bzw. der generierte Steuerstrom zusätzlich als Zündstrom dem Gate des GTO-Thyristors 2 zugeführt, so daß auch bei Ausfall des Einschaltkreises 4 bei Auftritt einer unzulässigen Überspannung diese durch Zünden des GTO-Thyristors 2 abgebaut werden kann.

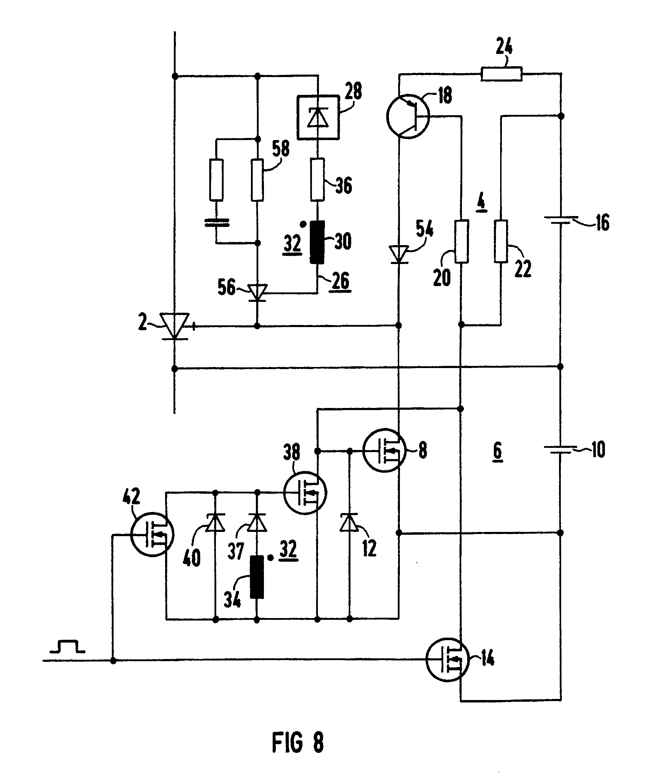

In Figur 8 ist eine weitere Schaltungsanordnung zur Durchführung des erfindungsgemäßen Verfahrens dargestellt. Bei dieser Schaltungsanordnung ist elektrisch parallel zur Anoden-Gate-Strecke des GTO-Thyristors 2 ein Zündthyristor 56 mit Strombegrenzungswiderstand 58 mit paralleler RC-Beschaltung geschaltet. Der GTO-Thyristor 2 kann auch eine Schutzbeschaltung 46 gemäß Schaltungsanordnung nach Figur 5 haben, wobei dann der Zündthyristor 56 mit dem Kondensator 44 zu verbinden ist. Die Spannungsfestigkeit des Zündthyristors 56 gleicht der des GTO-Thyristors 2. Elektrisch parallel zur Anoden-Gate-Strecke des Zündthyristors 56 ist die Reihenschaltung 26 mit dem spannungsbegrenzenden Element 28 und dem Kopplungselement 32 geschaltet. Sobald die Anodenspannung des GTO-Thyristors 2 in Bezug auf seine Kathodenspannung den vorbestimmten Grenzwert überschreitet, wird ein Steuersignal bzw. ein Steuerstrom generiert, das die negative Spannungsquelle 10 vom Gate abgeschaltet und die positive Spannungsquelle 16 an das Gate des GTO-Thyristors 2 angeschaltet wird bzw. der den Zündthyristor 56 zündet. Mit dem Zünden des Zündthyristors 56 wird der generierte Steuerstrom auch dem Gate des GTO-Thyristors 2 als Zündstrom zugeführt, wodurch der GTO-Thyristor 2 zündet. Auch bei dieser Schaltungsanordnung wird sichergestellt, daß unabhängig vom Zustand des Einschaltkreises 4 der GTO-Thyristor 2 bei Auftreten von Überspannungen schutzgezündet wird.

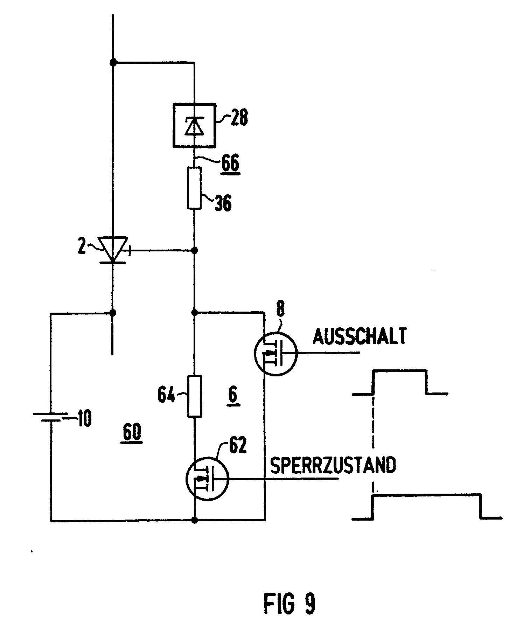

In Figur 9 ist ein GTO-Thyristor 2 dargestellt, dessen Ansteuerschaltung neben dem nicht näher dargestellten Einschaltkreis 4, einen Ausschaltkreis 6 und einen Sperrkreis 60 aufweist. Der Ausschaltkreis 6 besteht aus den selbstsperrenden MOSFET 8 und der Spannungsquelle 10, die an die Gate-Source-Strecke des GTO-Thyristors 2 schaltbar ist. Der Sperrkreis 60 besteht aus einem selbstsperrenden MOSFET 62 mit einem Drain-Widerstand 64 und der Spannungsquelle 10. Außerdem ist elektrisch parallel zur Anoden-Gate-Strecke des GTO-Thyristors 2 die Reihenschaltung 66 geschaltet, die aus einem spannungsbegrenzenden Element 28 und einem Widerstand 36 besteht. Wenn nun die Anodenspannung des GTO-Thyristors 2 in Bezug auf seine Kathodenspannungen einen vorbestimmten Grenzwert überschreitet, spricht das spannungsbegrenzende Element 28 an. Da die Gate-Source-Strecke des GTO-Thyristors 2 niederohmiger als der eingeschaltete Sperrkreis 60 ist, fließt der generierte Steuerstrom überwiegend als Zündstrom zum Gate des GTO-Thyristors 2 und zündet diesen, wodurch die anstehende Überspannung abgebaut wird. Bei dieser Schaltungsanordnung, wobei die Ansteuerschaltung des GTO-Thyristors 2 zusätzlich einen Sperrkreis 60 aufweist, braucht bei Überspannung nicht erst die negative Spannungsquelle 10 vom Gate abgeschaltet werden.

## Ansprüche

1. Verfahren zum Schutz eines mit einer aus einem Einschaltkreis (4) und einem Ausschaltkreis (6) bestehenden Ansteuerschaltung versehenen abschaltbaren Thyristors (2) vor unzulässiger Überspannung, wobei die Anodenspannung des abschaltbaren Thyristors (2) in Bezug auf seine Kathodenspannung überwacht wird und bei Überschreitung eines vorbestimmten Grenzwertes ein Steuersignal generiert wird, wodurch die am Gate des abschaltbaren Thyristors (2) angeschaltete negative Spannungsquelle (10) abgeschaltet und der abschaltbare Thyristor (2) mittels des Einschaltkreises (4) eingeschaltet wird.

2. Verfahren nach Anspruch 1, **dadurch gekennzeichnet,** daß das generierte Steuersignal dem Gate des abschaltbaren Thyristors (2) als Zündstrom zugeführt wird, wodurch dieser zündet.

3. Verfahren zum Schutz eines mit einer aus einem Einschaltkreis (4), einem Ausschaltkreis (6) und einem Sperrkreis (60) bestehenden Ansteuerschaltung versehenen abschaltbaren Thyristors (2) vor unzulässiger Überspannung, wobei die Anodenspannung des abschaltbaren Thyristors (2) in Bezug auf seine Kathodenspannung überwacht wird und bei Überschreitung eines vorbestimmten Grenzwertes ein Steuersignal generiert wird, das dem Gate des abschaltbaren Thyristors (2) als Zündstrom zugeführt wird.

4. Schaltungsanordnung zur Durchführung des Verfahrens nach Anspruch 1 mit einem abschaltbaren Thyristor (2), der mit einer Ansteuerschaltung versehen ist, die aus einem Einschaltkreis (4) und einem Ausschaltkreis (6) besteht, **dadurch gekennzeichnet,** daß elektrisch parallel zur Anoden-Kathoden-Strecke des abschaltbaren Thyristors (2) eine Reihenschaltung (26), bestehend aus einem spannungsbegrenzenden Element (28) und einem sendeseitigen Teil (30) eines Kopplungselementes (32), geschaltet ist, und daß ein empfangsseitiges Teil (34) des Kopplungselementes (32) derart mit dem Betätigungseingang des Ausschaltkreises (6) und mit dem Einschaltkreis (4) verbunden ist, daß der Ausschaltkreis (6) abschaltbar und der Einschaltkreis (4) einschaltbar sind.

5. Schaltungsanordnung zur Durchführung des Verfahrens nach Anspruch 1 mit einem abschaltbaren Thyristor (2), der mit einer aus einer Diode (48), einem Widerstand (50) und einem Kondensator (44) bestehenden Schutzbeschaltung (46) und mit einer Ansteuerschaltung versehen ist, die aus einem Einschaltkreis (4) und einem Ausschaltkreis (6) besteht, **dadurch gekennzeichnet, daß** elektrisch parallel zum Kondensator (44) der Schutzbeschaltung (46) eine Reihenschaltung (26), bestehend aus einem spannungsbegrenzenden Element (28) und einem sendeseitigen Teil (30) eines Kopplungselementes (32), geschaltet ist, und daß ein empfangsseitiger Teil (34) des Kopplungselementes (32) mit dem Betätigungseingang eines Schalters (38) verbunden ist, mit dem der Abschaltkreis (6) abschaltbar und der Einschaltkreis (4) einschaltbar sind.

6. Schaltungsanordnung zur Durchführung des Verfahrens nach den Ansprüchen 1 und 2 mit einem abschaltbaren Thyristor (2), der mit einer Ansteuerschaltung versehen ist, die aus einem Einschaltkreis (4) und einem Ausschaltkreis (6) besteht, **dadurch gekennzeichnet, daß** die Anode des abschaltbaren Thyristors (2) über eine Reihenschaltung (26), bestehend aus einem spannungsbegrenzenden Element (28), einem sendeseitigen Teil (30) eines Kopplungselementes (32) und einer Entkopplungsdiode (52), mit seinem Gate verknüpft ist und daß ein empfangsseitiger Teil (34) des Kopplungselementes (32) mit dem Betätigungseingang eines Schalters (38) verbunden ist, mit dem der Abschaltkreis (6) abschaltbar und der Einschaltkreis (4) einschaltbar sind.

7. Schaltungsanordnung zur Durchführung des Verfahrens nach den Ansprüchen 1 und 2 mit einem abschaltbaren Thyristor (2), der mit einer Ansteuerschaltung, die aus einem Einschaltkreis (4) und einem Ausschaltkreis (6) besteht, und mit einer aus einer Diode (48), einem Widerstand (50) und einem Kondensator (44) bestehenden Schutzbeschaltung (46) versehen ist, **dadurch gekennzeichnet, daß** der anodenseitige Anschluß des Kondensators (44) der Schutzbeschaltung (46) über eine Reihenschaltung (26), bestehend aus einem spannungsbegrenzenden Element (28), einem sendeseitigen Teil (30) eines Kopplungselementes (32) und einer Entkopplungsdiode (52), mit dem Gate des abschaltbaren Thyristors (2) verknüpft ist und daß ein empfangsseitiger Teil (34) des Kopplungselementes (32) mit dem Betätigungseingang eines Schalters (38) verbunden ist, mit dem der Ausschaltkreis (6) abschaltbar und der Einschaltkreis (4) einschaltbar sind.

8. Schaltungsanordnung zur Durchführung des Verfahrens nach den Ansprüchen 1 und 2 mit einem abschaltbaren Thyristor (2), der mit einer Ansteuerschaltung, die aus einem Einschaltkreis (4) und einem Ausschaltkreis (6) besteht, versehen ist, **dadurch gekennzeichnet, daß** elektrisch parallel zur Anoden-Gate-Strecke des abschaltbaren Thyristors (2) ein Zündthyristor (56) mit einem Vorwiderstand (58) mit paralleler RC-Beschaltung geschaltet ist, wobei das Gate des Zündthyristors (56) über eine Reihenschaltung (26), bestehend aus einem spannungsbegrenzenden Element (28) und einem sendeseitigen Teil (30) eines Kopplungselementes (32), mit der Anode des abschaltbaren Thyristors (2) verknüpft ist, und daß ein empfangsseitiger Teil (34) des Kopplungselementes (32) mit dem Betätigungseingang eines Schalters (38) verbunden ist, mit dem der Abschaltkreis (6) abschaltbar und der Einschaltkreis (4) einschaltbar sind.

9. Schaltungsanordnung zur Durchführung des Verfahrens nach Anspruch 3 mit einem abschaltbaren Thyristor (2), der mit einer Ansteuerschaltung, die aus einem Einschaltkreis (4), einem Ausschaltkreis (6) und einem Sperrkreis (60) besteht, versehen ist, **dadurch gekennzeichnet, daß** elektrisch parallel zur Anoden-Gate-Strecke des abschaltbaren Thyristors (2) eine Reihenschaltung (66), bestehend aus einem spannungsbegrenzenden Element (28) und einem Widerstand (36), geschaltet ist.

10. Schaltungsanordnung nach einem der Ansprüche 5 bis 8, **dadurch gekennzeichnet, daß** als Schalter (38) ein rücksetzbarer Schalter vorgesehen ist.

11. Schaltungsanordnung nach einem der Ansprüche 5 bis 8, **dadurch gekennzeichnet, daß** als Kopplungselement (32) ein Übertrager vorgesehen ist.

12. Schaltungsanordnung nach einem der Ansprüche 5 bis 8, **dadurch gekennzeichnet, daß** als Schalter (38) ein selbstsperrender Metalloxidschicht-Feldeffekttransistor vorgesehen ist, zu dessen Gate-Emitter-Strecke der empfangsseitige Teil (34) des Kopplungselementes (32) mit einer Entkopplungsdiode (37) und eine Zenerdiode-Diode (40) elektrisch parallel geschaltet sind.

13. Schaltungsanordnung nach den Ansprüchen 10 und 12, **dadurch gekennzeichnet, daß** die Gate-Emitter-Strecke des selbstsperrenden Metalloxidschicht-Feldeffekttransistor (38) mittels eines weiteren selbstsperrenden Metalloxidschicht-Feldeffekttransistor (42) überbrückbar ist, wobei dessen Gate mit dem Eingang des Einschaltkreises (4) verknüpft ist.

14. Schaltungsanordnung nach einem der Ansprüche 4 bis 9, **dadurch gekennzeichnet, daß** als spannungsbegrenzendes Element (28) eine Kippdiode vorgesehen ist.

15. Schaltungsanordnung nach einem der Ansprüche 4 bis 9, **dadurch gekennzeichnet, daß** als spannungsbegrenzendes Element (28) eine Reihenschaltung eines Varistors mit einer Trigger-Diode vorgesehen ist.

16. Schaltungsanordnung nach einem der Ansprüche 4 bis 9, **dadurch gekennzeichnet,** daß als spannungsbegrenzendes Element (28) eine Reihenschaltung einer Zener-Diode mit einer Trigger-Diode vorgesehen ist.

FIG 1

FIG 2

FIG 3

FIG 4

FIG 5

EP 0 431 215 A1

FIG 6

13

FIG 7

**FIG 8**

FIG 9

Europäisches
Patentamt

# EUROPÄISCHER RECHERCHENBERICHT

Nummer der Anmeldung

EP 89 12 2721

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 176 800 (SIEMENS) * Seite 19, Zeile 12 - Seite 25, Zeile 24; Figuren 3-5 * --- | 1,2,4,7 ,14 | H 03 K 17/08 |
| Y | DE-A-3 311 426 (SIEMENS) * Seite 5, Zeile 28 - Seite 6; Figur * | 1,2,4,7 ,14 | |
| A | --- | 6 | |
| A,D | ELEKTRONIK, Band 33, Nr. 21, 19. Oktober 1984, Seiten 91-96, München, DE; A. HONDA: "Optimierte Ansteuerschaltungen für GTO-Thyristoren" * Seite 96, Figur 29 * ----- | 5 | |

|  |  |
|---|---|
| | RECHERCHIERTE SACHGEBIETE (Int. Cl.5) |
| | H 03 K |

Der vorliegende Recherchenbericht wurde für alle Patentansprüche erstellt

| Recherchenort | Abschlußdatum der Recherche | Prüfer |
|---|---|---|
| DEN HAAG | 23-07-1990 | CANTARELLI R.J.H. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
......................................................................
& : Mitglied der gleichen Patentfamilie, übereinstimmendes
    Dokument

EPO FORM 1503 03.82 (P0403)